# EUROPEAN PATENT SPECIFICATION

(11) **EP 3 065 516 B1**
(45) Date of publication and mention of the grant of the patent: **02.01.2019**
(21) Application number: 15169245.6
(22) Date of filing: 26.05.2015
(51) Int. Cl.: H05K 3/28, H05K 5/06

(54) **POLYMERIC MULTI-LAYERED INJECTION-MOULDED ARTICLE WITH AN ELECTRIC CIRCUIT, PRODUCTION METHOD THEREOF**
MEHRSCHICHTIGES POLYMERSPRITZGUSSTEIL MIT EINER ELEKTRISCHEN SCHALTUNG, HERSTELLUNGSVERFAHREN DAFÜR
ARTICLE MOULÉ PAR INJECTION MULTICOUCHE POLYMÈRE AVEC UN CIRCUIT ÉLECTRIQUE, PROCÉDÉ DE FABRICATION DE CELUI-CI

(30) Priority: 03.03.2015 PT 15108266 U
(43) Date of publication of application: 07.09.2016
(73) Proprietor: Simoldes Plásticos, SA, Oliveira de Azeméis, 3721-902 Santiago de Riba-UL (PT)
(72) Inventor: Magalhães Ribeiro Da Cunha Melo, Sandra Rafaela, 4450-732 LEÇA DA PALMEIRA (PT); Alves Da Silva, Ana Sofia, 4430-548 VILA NOVA DE GAIA (PT); Simões Costa, Hugo Filipe, 4760-689 VILA NOVA DE FAMALICÃO (PT); Gonçalves, António Miguel, 4770-277 JOANE (PT); Oliveira Da Silva, José Fernando, 4445 ALFENA (PT); De Carvalho Gomes, João Manuel, 4700-832 RUÍLHE (PT); Trindade Morgado Rodrigues, Lúcia, 4800-039 GUIMARÃES (PT); Campos De Oliveira, Cristina Manuela, 4805-019 BRITO (PT); De Sousa Bessa Soares, João Luís, 4470-051 MAIA (PT)
(74) Representative: Silvestre de Almeida Ferreira, Luís Humberto

(56) References cited:
- US-A1- 2006 012 034
- US-A1- 2006 198 128
- US-A1- 2010 246 146

## Description

### Technical field

The present disclosure relates to a polymeric multi-layered injection-moulded article with an electric circuit, in particular for lighting and sensing performances for the interior of a vehicle, the interior compartment of a vehicle and/or for the identification of a possible obstacle for a driver. The present disclosure also relates to a process to obtain a final article - an injected plastic article and an injected plastic covered by a textile layer, and production methods thereof.

### Background

The DE102011105190 A1 and DE102011117985 A1 concern to a plastic part and a method for producing it for use in automotive industry. The DE102011105190 A1 regards in particular to a transparent plastic part, while the DE102011117985 A1 document concerns an electronic device with a plastic part-integrated touch sensor.

US2010246146 refers to a method of producing an electronic device and includes a holding of a circuit board and a decoration sheet in a cavity of a mould, and a filling and solidifying the thermosetting resin in the cavity.

US2006198128 refers to methods and means for embedding electronic components, such as LED-based light sources and associated control circuitry, into moulded or continuously cast surface materials.

The document DE102013101064 A1 relates to a film with at least one electrical or electronic function layer.

The documents previously mentioned present several shortcomings, which the present disclosure overcomes. The documents refer to metal mesh printed on a polyethylene terephthalate (PET) with a screen print roll-to-roll (R2R) system. The technology used is the vacuum in-mould labelling and the plastic used is a transparent ABS thermoplastic. Moreover; the fabricated piece is entirely made of plastic and includes a touch-sensitive panel with integrated sensing.

These facts are disclosed in order to illustrate the technical problem addressed by the present disclosure.

### General Description

One aspect of the present invention relates to a polymeric multi-layered injection-moulded article comprising an electric circuit, said article comprising:
a laminated foil;
an injection-moulded part, in which the laminated foil has been embedded by injection-moulding, flush with one surface of the injection-moulded part;
wherein said laminated foil comprises:
   a circuit support layer composed of a thin flexible sheet of polymeric material;
   one or more electrically conductive circuit traces printed on one side of said support layer;
   one or more electrically conductive crimping connectors, each crimped to the support layer and a conductive circuit trace;
   an encapsulation layer composed of a thin flexible sheet of polymeric material,
wherein said support layer, circuit traces, crimping connectors and encapsulation layer have been laminated together in the laminated foil; and
wherein the crimping connectors and the encapsulation layer are placed such that the crimping connectors protrude from the outermost layer of the injection-moulded article.

In the prior art a circuit label protrudes out of the mould from the final piece, the connections will be brittle and have unprotected conductive tracks, which will deteriorate easily. The injected plastic according to the disclosure enhances the mechanical resistance of the circuit label by embedding it.

In the prior art, electrostatic IML could not be applied to the existing circuit labels. These had exposed metallic contacts which could:
discharge the attachment electrostatic charge and prevent the label attachment to the mould before injection;
cause electrostatic sparking inside the mould;
release discharge electrostatic charge and damage the electronic components of the circuit label.

In the present disclosure, the crimped connectors enable a direct connection to the external surface of the injection-moulded article, for example by soldering conductive wiring, dispensing with recesses or scraping injection material to reach the circuit electric contacts.

Other embodiment of the article of the present invention relates to a polymeric multi-layered injection-moulded article that may further comprise one or more electronic components disposed on the same side of the support layer as the circuit trace or traces, said components being electrically connected to said circuit trace or traces and said electronic components have been also laminated together in the laminated foil.

In another embodiment, the laminated foil may be embedded in the injection-moulded part with the encapsulation layer facing the injection-moulded part.

In another embodiment, the encapsulation layer may be transparent or translucent white or translucent coloured.

In another embodiment of the article of the present invention the laminated foil may be embedded in the injection-moulded part with the support layer facing the injection-moulded part.

In another embodiment, the laminated foil the support layer may be transparent or translucent white or translucent coloured.

In another embodiment, the laminated foil may further comprise a secondary encapsulation layer covering the crimping connectors in the area of the support layer where the crimping connectors protrude.

In another embodiment of the article of the present invention the encapsulation layer can be extended to the area of the support layer where the crimping connectors protrude.

In another embodiment, the laminated foil further comprises a secondary encapsulation layer covering the crimping connectors in the area of the encapsulation layer where the crimping connectors protrude.

In another embodiment, the electronic components may be light-emitting diodes - LED's, electroluminescent lamps, resistors or a combination thereof.

In another embodiment, the conductive circuit traces printed may use a silver based paste.

In another embodiment, the electronic components are electrically connected to said circuit trace or traces by silver based paste or by secondary crimping connectors.

In another embodiment, the article may further comprise a textile or non-textile material or their mixtures covering the injection-moulded part (2), in particular on the opposite side of the side where the laminated foil is embedded. Namely, the final piece could comprise a single or a multi-layer structure. The multi-layer structures may involve two or three layers namely: decorative fabric, foam (ex.: PUR, coPA, co PES) and a backing material, that could be assembled by flat-bed, hot-melt or flamebonding processes. In another embodiment, the textile material may be one of the following:
knit fabrics (ex.: jersey, piquet, double face, tricot, spacer fabrics),
woven fabrics (ex: plain weave, twill),
velvet, alcantara; leather or synthetic leather (ex: PVC, TPO, TEP).
nonwoven fabrics (ex.: Needlepunched, spunlaced, thermobonded, spunbonded, stitchbonded).

In another embodiment, the thickness of the support layer may vary between 25 - 150 micrometres, preferably between 50 - 125 micrometres, more preferably between 75 - 105 micrometres.

In another embodiment, the thickness of the laminated foil may vary between 100 - 2000 micrometres, preferably between 100 - 1000 micrometres, more preferably between 170 - 800 micrometres.

In another embodiment, the support layer may be provided with an adhesive layer.

In another embodiment, the support layer may be a polymeric material selected from a list consisting of: polyolefins and polyesters, more preferable polyethylene, polypropylene, and polyethylene terephthalate, polyethylene terephthalate glycol, or mixtures thereof. Preferably the support layer (5) is one of the following Yupo™ FPU 80, Yupo™ AISE 105, Yupo™ IHC 75, Adhesive PETG, PET Hostaphan and/or PET Melinex.

In another embodiment of the article of the present invention the encapsulation material may be polyethylene terephthalate glycol.

In another embodiment of the article of the present invention the encapsulation layer (8) may be provided with an adhesive layer.

In another embodiment of the article of the present invention the article may be a car pillar, a car door panel, a car door, a car armrest, a car console, a car instrument panel, a car glove box compartment, a car trunk door, a car trunk panel, or baby seat car or an electric home appliance.

The polymeric multi-layered injection-moulded article of the present invention is obtained by in-mould labelling, in some embodiments the injection-moulded article may further comprise a textile.

Other aspect of the present disclosure is related to a car comprising one or more polymeric multi-layered injection-moulded article disclosed in the present invention.

An aspect of the disclosure relates to a method for producing a polymeric multi-layered injection-moulded article comprising an electric circuit, said method comprising the following steps:
placing a laminated foil as described in any one of the claims 1-22 in a mould for injection-moulding the article, wherein the laminated foil is provided additionally with a removable protective layer element (8') covering the crimping connectors (3) in the area where the crimping connectors (3) protrude, such that the laminated foil does not present any conductive element to its exterior;
applying an electrostatic charge on the laminated foil for charging it electrostatically and attaching said laminated foil to the mould;
closing the mould and injecting the plastic material for obtaining an injection-moulded part (2), wherein the laminated foil is embedded by the injection-moulded part, flush with one surface of the injection-moulded part;
removing the removable protective layer element (8');
wherein the crimping connectors (3) and the encapsulation layer (8) are placed such that the crimping connectors (3) will protrude from the outermost layer of the injection-moulded article.

An embodiment comprises, before closing the mould, placing of a textile material in the mould and attaching to the mould, in particular at an opposite location in respect of the laminated foil.

An embodiment comprises the following steps before laminating the laminated foil:
printing the circuit trace or traces (4) with a silver based paste using roll-to-roll screen printing;
drying the printed circuit trace or traces in an oven at 90 °C -160 °C;
placing the electronic component or components (7) on the support layer (5) with or without adhesive,
applying silver paste for electrically connecting the electronic component or components (7) to the circuit trace or traces (4);
drying in an oven at 90 °C - 160 °C, preferably at 90 °C - 140 °C, more preferably at 100 °C - 130 °C,
crimping the crimping connector or connectors (3), each crimped to the support layer (5) and a conductive circuit trace (4);
encapsulating with the encapsulation adhesive layer (8) by means of a laminating step.

In an embodiment, the adhesive is a liquid or semi solid adhesive.

In an embodiment, the encapsulating is with 1-5 bar pressure and 20-120 °C temperature, more preferably 3 - 4 bar.

In an embodiment, the article is a car pillar, a car door panel, a car door, a car armrest, a car console, a car instrument panel, a car glove box compartment, a car trunk door, or a car trunk panel, or baby seat car or an electric home appliance.

In an embodiment, the removable protective layer element (8') is obtained from the protective carrier layer of the encapsulation layer (8) or of the support layer (5).

In an embodiment, a PCB is attached to the crimping connectors, in particular by soldering/bonding and or welding and conductive solid state bonding materials, or by coupling connectors to the crimping connectors.

In an embodiment, a silver paste to print in proper substrates, using a sheet to sheet or a R2R system and wherein the encapsulation is made using proper labels. The technology used involves electric discharge IML, the injection process is possible to be scale-up and the polymers may be used with or without charge/filler, with and without colouring dyes. Furthermore, the plastic piece may be covered with textile substrate, which none of the mentioned documents refer or purpose. The plastic piece may be used for sensing and lighting.

The in-mould labelling (IML) involves the use of paper or plastic labels which will be ultimately form a part of the moulded end-product. The IML effectively eliminates the need for a separate labelling process following the manufacture of the part, which reduces labour and equipment costs. Therefore, the use of IML at an industrial scale is highly advantageous.

The IML products comprise a label, which may be a polymeric film, on which a decorative pattern is printed. The adhesion of such labels to a polymeric article can be enhanced by applying a heat sealable layer (e.g. a film or a coating) onto the backing side (i.e., not printed surface) of the in-mould label which is to be in contact with the polymeric article. The in-mould label may be cut to the desired shape and size from a larger sheet of the label material, using label cutting apparatus.

The present disclosure allows to improve the lighting and sensing performances for the interior of a vehicle, the interior compartment of a vehicle and/or for the identification of a possible obstacle for a driver using articles obtained by IML.

This solution presents several advantages when compared with the documents previously mentioned, as it is achieved by means of sensor integration and also lighting integration as light emitting diode (LED) and/or electroluminescent (EL) lamp may be incorporated in the present solution; additionally, the visual covering could be injected plastic or textile as the present solution is not restricted to in-mould decoration (IMD) and the connection process is more efficient as the ones described in the documents above-mentioned.

This disclosure has a wide range of applications in the automobile sector as it may be applied in decorative lighting, in low lighting applications, in normal lighting applications and in sensing applications. Decorative lighting and low lighting are understood as applications designed with the purpose of, for example, indicating the presence of objects, attract the attention of the driver, and/or make the ambient more comfortable. Lighting applications are understood as all the application wherein the lighting is used for illuminating the dark areas of a given vehicle, for example, and facilitate the search of objects. Sensing applications are understood as applications wherein in low-light environments, a proximity sensor is able to activate a light indicating the position of a given object (such as the open/close window status). Also sensing applications are applications to open/ close the door car window or open the glove compartment, for example.

The term "comprising" whenever used in this document is intended to indicate the presence of stated features, integers, steps, components, but not to preclude the presence or addition of one or more other features, integers, steps, components or groups thereof.

### Brief description of the drawings

The following figures provide preferred embodiments for the present disclosure and should not be seen as limiting the scope of the disclosure.
**Figure 1** illustrates a plastic article wherein 1 represents the location where the plastic label conductive track breaks in the prior art document provided.
**Figure 2** illustrates an embodiment of a laminated foil for a polymeric multi-layered injection-moulded article wherein 2 represents an EL.

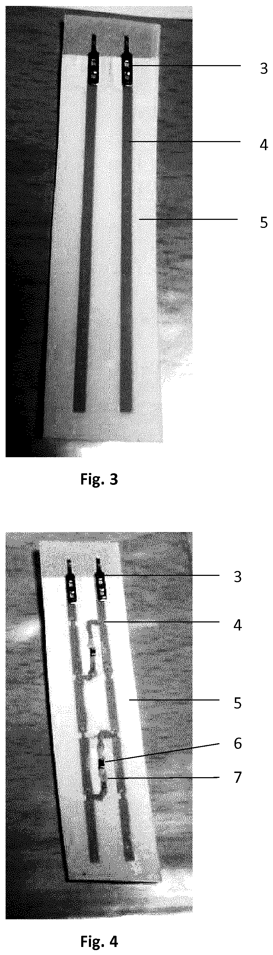

**Figure 3** illustrates an embodiment of a laminated foil for a polymeric multi-layered injection-moulded article comprising an electric circuit wherein:
   3 represents a crimping;
   4 represents a conductive track;
   5 represents a printing substrate as a support layer.
**Figure 4** illustrates an embodiment of a polymeric multi-layered injection-moulded article wherein:
   3 represents a crimping connector;
   4 represents a conductive trace or track;
   5 represents a printing substrate as a support layer;
   6 represents a resistor;
   7 represents a LED.
**Figure 5** illustrates an embodiment of a polymeric multi-layered injection-moulded article wherein:
   2 represents an injection-moulded part;
   3 represents a crimping connector;
   4 represents a conductive trace or track;
   5 represents a printing substrate as a support layer;
   7 represents a LED;
   8 represents an encapsulation layer;
   8' represents a removable protective layer element;
   9 represents a secondary encapsulation layer;
   11 represents a silver paste connection;
   12 represents a light emission direction;
   13 multilayer label (laminated foil).

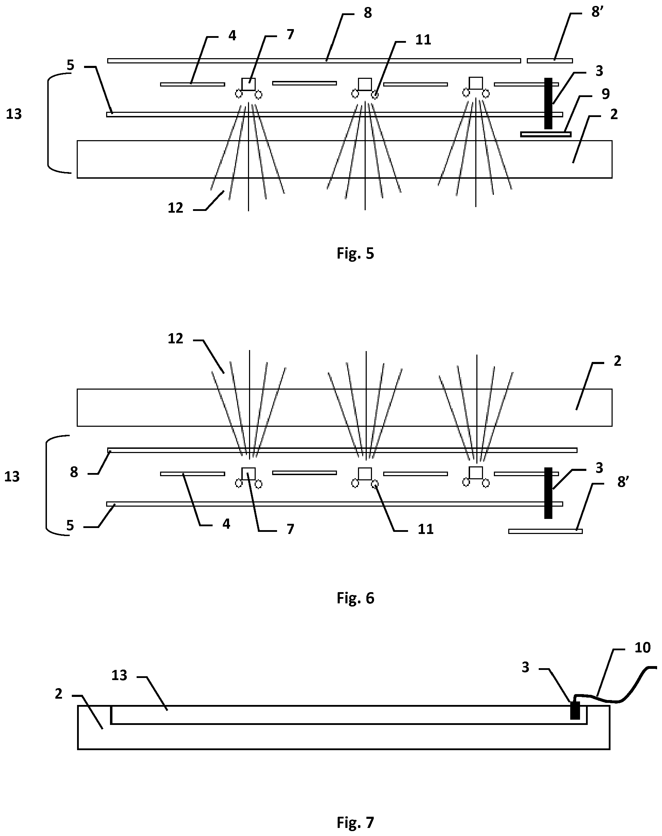

**Figure 6** illustrates an embodiment of a polymeric multi-layered injection-moulded article wherein:
   2 represents an injection-moulded part;
   3 represents a crimping connector;
   4 represents a conductive trace or track;
   5 represents a printing substrate as a support layer;
   7 represents a LED;
   8 represents an encapsulation layer;
   8' represents a removable protective layer element;
   11 represents a silver paste connections;
   12 represents a light emission direction;
   13 multilayer label (laminated foil).
**Figure 7****:** illustrate an embodiment of a polymeric multi-layered injection-moulded article wherein
   2 represents an injection-moulded part;
   3 represents a crimping connector;
   10 represents a conductor wire;
   13 multilayer label (laminated foil).

### Detailed description

In an embodiment of the elements which are part of the end paper or plastic piece, which may be covered with textile. Moreover, the process to obtain the final article is also disclosed in full detail.

In an embodiment of the polymeric multi-layered injection-moulded article describes said article comprising a laminated foil; an injection-moulded part (2), in which the laminated foil has been embedded by injection-moulding, flush with one surface of the injection-moulded part; wherein said laminated foil comprises: a circuit support layer (5) composed of a thin flexible sheet of polymeric material; one or more electrically conductive circuit traces (4) printed on one side of said support layer; one or more electrically conductive crimping connectors (3), each crimped to the support layer and a conductive circuit trace; an encapsulation layer (8) composed of a thin flexible sheet of polymeric material, wherein said support layer, circuit traces, crimping connectors and encapsulation layer have been laminated together in the laminated foil; and wherein the crimping connectors and the encapsulation layer are located such that the crimping connectors are directly the injection-moulded part.

In an embodiment of the polymeric multi-layered injection-moulded article describes a circuit support layer (substrate), the silver paste, the electric material, the electronic material, and the encapsulation substrate are properly assembled; the injection process by IML may be conducted and the end piece is obtained.

In an embodiment of the polymeric multi-layered injection-moulded article, in table 1 several examples of material of the circuit support layer are disclosed. The circuit support layer may comprise polymeric base materials, like polyolefin such as polypropylene (PP), or polyethylene (PE); or polyesters, such us polyethylene terephthalate (PET) and polyethylene terephthalate glycol (PETG).

**Table 1: Examples of material of the circuit support layer (substrate)**

| **Substrate** | **Thickness (µm)** | **Base material** | **Colour** |
|---|---|---|---|
| Yupo®FPU 80 | 80 | PP | white |
| Yupo®AISE 105 | 105 | PP or PE | white |
| Yupo®IHC 75 | 75 | PP or PE | transparent |
| Adhesive PETG | 96 | PETG | transparent |
| PET Hostaphan | 75 | PET | transparent |
| PET Melinex | 125 | PET thermally stabilized | transparent |

In an embodiment, circuit support layer (substrates) may be transparent, white or coloured, according to the final application of the end-product. Transparent, white or coloured when have a textile as decorative layer; White or coloured or transparent when the injected plastic is the decorative layer, for example.

In an embodiment of the polymeric multi-layered injection-moulded article, in table 1 several examples of the circuit support layer (substrate) may be one of the following: Yupo®AISE and Yupo®IHC substrates are labels largely used in the IML process, and compatible with it. The PETG is not largely used, however it is still compatible with the IML process.

Normally, PET substrates (Hostaphan PET or Melinex PET) are not used with the IML process because they do not adhere to the injected plastic. However PET substrates were also used because they show advantages during the printing process of the support layer, namely during the drying step it is possible to use higher temperatures (140 °C - 160 °C) than when other substrates are used. Some substrates such as Yupo and PETG may have a temperature limitation, as 130 °C which not be exceeded as the properties of the substrate used could be compromised. Furthermore, the PET substrates are highly transparent, which depending on the final application is an advantage to the use of PET instead of other substrates.

In the multilayered structure at least one substrate, the support layer or the encapsulation substrate, must be compatible with the IML process as this will enable the multilayered structure to adhere to the mould.

In an embodiment, the encapsulation substrate used in the solution now disclosed was adhesive PETG and all the samples were encapsulated. Encapsulation is done through a laminating process under pressure at room temperature. Other kinds of encapsulation substrate may be used, like polyolefins or other polyesters films; however they need to have an adhesive layer (pressure activated at room or higher temperatures - till 140 °C). The encapsulation step is performed because silver tracks oxidize in contact with air, disenabling the electric conduction signal.

In an embodiment, support layer (substrates) used for encapsulation layer may be transparent, white or coloured.

Table 2 illustrates individual thicknesses of the support layer (75-125 µm), the electric or electronic materials (5 -838 µm, preferably 50 - 212 µm), as well as the laminated foil (174-790 µm) and some examples of the material used.

**Table 2: Examples of individual layer materials and thicknesses**

| **Material** | **Thickness (µm)** |
|---|---|
| Yupo®FPU 80 | 80 |
| Yupo®AISE 105 | 105 |
| Yupo® IHC 75 | 75 |
| PET Hostaphan GN 50 4660 | 75 |
| PET Melinex ST504 | 125 |
| Adhesive PETG | 96 |
| Adhesive PETG + substrate | 96+56 (152) |
| Dried silver layer | 5 |
| Male crimping | 212 |
| Miniaturized LED | 400 |
| Resistor | 450 |
| EL | 338-838 |
| Multilayer deposited on Yupo®FPU with or without LEDs | 174-695 |
| Multilayer deposited on Yupo®AISE with or without LEDs | 204-697 |
| Multilayer deposited on Yupo®IHC with or without LEDs | 181-710 |
| Multilayer deposited on PET Hostaphan GN 50 4660 with or without LEDs | 175-790 |
| Multilayer deposited on PET Melinex ST504 with or without LEDs | 229-738 |

In an embodiment, the process to integrate sensing and lighting using the IML process inhere disclosed comprises the following steps:
printing the conductive tracks (enabling electric conduction) with silver paste on the selected substrate using a screen printing roll-to-roll (R2R) system;
drying step of the conductive tracks with silver paste in an oven with temperatures between 90 °C - 160 °C;
setting the electronic components by means of an adhesive,
placing from 0.1 - 10 µL of the liquid adhesive, at the site where the electronic materials will be placed;
dispensing the liquid adhesive with a dispensing equipment, at the site where the electronic materials will be placed;
drying of the liquid adhesive at room temperature;
placing of LEDs, in particular, and resistors using proper equipment, such as a Pick & Place equipment high brightness miniaturized;
dispensing from 0.1 - 10 µL of the silver paste with the dispensing equipment in the required locations making connections between LEDs, resistors and silver conductive tracks;
drying step in a R2R oven system is necessary from 90 °C - 160 °C;
cutting of one end of the printed labels with a laser until the silver track zone;
crimping the male crimp at the end of all silver tracks, enabling the connection between the silver tracks and electronic components after injection process;
encapsulating by means of a laminating step using an adhesive layer with pressure and temperature;
placing the labels and EL lamps into the desired mould zone (male or female, according to the required application), which could have an abasement 2 to 3 times the label thickness;
electrical discharging on the labels and/ or the EL lamps and a semi- rigid PCB to charge them electrostatically and attaching them to the mould;
closing of the mould;
initiating of the injection process;
covering the final piece with textile or with injected plastic, during or after the injection process, or even leaving the injected plastic with no textile layer.

In the process above-described, the adhesive used may be liquid to enable the use of the dispensing equipment. The adhesive may be transparent, translucent or coloured if, for example, it is to be placed on the LED light direction or it may be coloured. Furthermore, the adhesive used in the process disclosed is an adhesion promoter indicated for polyolefin (PP or PE). Adhesive film can also be used.

Each plastic piece with label/ EL lamps incorporated presents a PCB (or a insert) which controls all the system.

In an embodiment, the injection-moulded part will protect the label/ ELs lamps, and PCB.

In an embodiment, said insert may include an insulating film, like polyvinyl chloride (usually material thickness is 600 µm; or between 200-1300 µm) or other material with identical dielectric properties (200-1300 µm).

In an embodiment, male crimpings are soldered to PCB. The said insert article may be soldered, bonded or clipped to the injection moulded part

The laminated foil is cut to size with laser equipment, wherein the final structures may be formed by:
- FPU/ silver + crimping / PETG
- FPU/ silver + LEDs + resistors + crimping / PETG
- AISE/ silver + crimping / PETG
- AISE/ silver + LEDs + resistors + crimping / PETG
- IHC/ silver + crimping / PETG
- IHC/ silver + LEDs + resistors + crimping / PETG
- PETG / silver + crimping / PETG
- PETG / silver + LEDs + resistors + crimping / PETG
- PET/ silver + crimping / PETG
- PET/ silver + LEDs + resistors + crimping / PETG

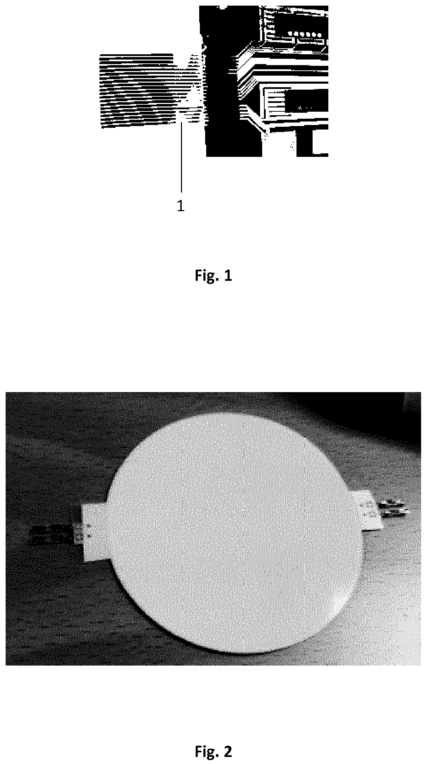

In an embodiment, other printed electronics structures may be injected, like electroluminescent lamps (ELs), Figure 2. The ELs are multi-layered printed structures that can have the design and size indicated for each application. In the EL contacts it is crimp male crimping. This will enable the connection between EL lamp and electronic components after injection process.

In an embodiment, the articles disclosed allows to obtain:
- structures without LEDs and ELs (with conductive tracks);
- structures with LEDs (with conductive tracks);
- structures with ELs lamps (without conductive tracks);
- structures with ELs lamps (with conductive tracks);
- structures with ELs and LEDs (with conductive tracks).

In an embodiment, the structures without LEDs and ELs have the functions of conductive track and sensing. The structures with LEDs and ELs with conductive tracks have the functions of lighting, conductive tracks and sensing, while the structures with ELs without conductive tracks have the function of lighting.

In an embodiment, other possibilities for substrates, electric materials and multilayer structures may have different thickness:
- substrates: (25-350) µm; preferably (75-125 µm);
- encapsulation layer: (25-350) µm; preferably (75-125 µm);
- electric materials: (100-1300 212) µm; preferably (212-1300) µm;
- multilayer structure: (100-2000) µm; preferably (100-790) µm.

In an embodiment, the industrial injection conditions may include within the following general conditions:
- Thermoplastic material: crystalline, amorphous and elastomers;
- Thermoplastic colour: natural or coloured;
- Melt mass temperature injection: 160 to 400 °C;
- Mould temperature: 0 to 150 °C.

The present disclosure for injected plastics may have several uses in decorative material, automotive industrial: decorative lighting / low lighting applications; lighting sensing.

The articles of the present subject-matter in decorative lighting and in low lighting applications may be applied in pillars, car doors, armrests, consoles, glove box compartments, car trunks, instrument panels or other plastic injected articles with the purpose of illuminating dark areas of a given vehicle and therefore facilitating the search of objects on the vehicle, vehicle entrance or other. The functionality of these plastic injected articles is to indicate the presence of an object, attract the attention of the driver, make the ambient more cosy or other.

As for sensing, the developments may be applied in pillars, car doors, armrests, consoles, instrument panels or other plastic injection-moulded article with the purpose of a proximity sensor activating a light indicating the cup holder location in low light environments, open the glove box compartment, actuation on the car window or other.

The above-mentioned embodiments are combinable with each other.

The following claims set out particular embodiments of the disclosure.

## Claims

1. A polymeric multi-layered injection-moulded article comprising an electric circuit, said article comprising:
a laminated foil;
an injection-moulded part (2), in which the laminated foil has been embedded by injection-moulding, flush with one surface of the injection-moulded part;
wherein said laminated foil comprises:
a circuit support layer (5) composed of a thin flexible sheet of polymeric material;
one or more electrically conductive circuit traces (4) printed on one side of said support layer (5);
one or more electrically conductive crimping connectors (3), each crimped to the support layer (5) and a conductive circuit traces (4);
an encapsulation layer (8) composed of a thin flexible sheet of polymeric material,
characterized for said support layer (5), circuit traces (4), crimping connectors (3) and encapsulation layer (8) have been laminated together in the laminated foil; and
wherein the crimping connectors (3) and the encapsulation layer (8) are placed such that the crimping connectors (3) protrude from the outermost layer of the injection-moulded article,
wherein the laminated foil is embedded in the injection-moulded part (2) with the encapsulation layer (8) facing the injection-moulded part (2)
wherein the laminated foil comprises additionally a removable protective layer element (8') covering the crimping connectors (3) and the support layer (5) in the area where the crimping connectors (3) protrude, such that the laminated foil does not present any conductive element to its exterior.

2. Article according to claim 1 further comprising one or more electronic components (6, 7) disposed on the same side of the support layer (5) as the circuit trace or traces (4), said components (6, 7) being electrically connected to said circuit trace or traces (4) and said electronic components (6, 7) have also been laminated together in the laminated foil.

3. Article according to the previous claim wherein the encapsulation layer (8) is transparent or translucent white or translucent coloured.

4. Article according to claim 1 or 2 wherein the laminated foil is embedded in the injection-moulded part (2) with the support layer (5) facing the injection-moulded part (2).

5. Article according to claim wherein the laminated foil comprises additionally a secondary encapsulation layer (9) covering the crimping connectors (3) and the support layer (5) in the area where the crimping connectors (3) protrude.

6. Article according to any one of the claims 4 - 5 wherein the laminated foil comprises additionally a removable protective layer element (8') covering the crimping connectors (3) and the conductive traces (4) in the area where the crimping connectors (3) protrude, such that the laminated foil does not present any conductive element to its exterior.

7. Article according to any one of the previous claims wherein the electronic components are light-emitting diodes - LED's, electroluminescent lamps, resistors or a combination thereof.

8. Article according to any one of the previous claims wherein the conductive circuit traces (4) are printed using a silver based paste.

9. Article according to any one of the previous claims wherein the electronic components are electrically connected to said circuit trace or traces by silver based paste or by secondary crimping connectors.

10. Article according to the previous claims further comprising a textile or non textile material or their mixtures covering the injection-moulded part (2).

11. Article according to any one of the previous claims wherein the thickness of the support layer (5) is between 25 - 150 micrometres, preferably between 50 - 125 micrometres, more preferably between 75 - 105 micrometres.

12. The article according to any one of the previous claims wherein the thickness of the laminated foil is between 100 - 2000 micrometres, preferably between 150 - 1000 micrometres, more preferably between 170 - 800 micrometres.

13. Article according to any one of the previous claims wherein the support layer (5) is a polymeric material selected from a list consisting of: polyolefin, polyethylene, polypropylene, polyesters, polyethylene terephthalate, polyethylene terephthalate glycol, or mixtures thereof.

14. Article according to the previous claims wherein the encapsulation material is polyethylene terephthalate glycol.

15. Article according to the previous claims wherein the article is a car pillar, a car door panel, a car door, a car armrest, a car console, a car instrument panel, a car glove box compartment, a car trunk door, or a car trunk panel, or baby seat car or an electric home appliance.

16. Car comprising an article described in any of the previous claims.

17. Method for producing a polymeric multi-layered injection-moulded article comprising an electric circuit, said method comprising the following steps:
placing a laminated foil as described in any one of the claims 1-16 in a mould for injection-moulding the article, wherein the laminated foil is provided additionally with a removable protective layer element (8') covering the crimping connectors (3) in the area where the crimping connectors (3) protrude, such that the laminated foil does not present any conductive element to its exterior;
applying an electrostatic charge on the laminated foil for charging said foil electrostatically and attaching said laminated foil to the mould;
closing the mould and injecting the plastic material for obtaining an injection-moulded part (2), wherein the laminated foil is embedded by the injection-moulded part, flush with one surface of the injection-moulded part;
removing the removable protective layer element (8');
wherein the crimping connectors (3) and the encapsulation layer (8) are placed such that the crimping connectors (3) will protrude from the outermost layer of the injection-moulded article.

## Patentansprüche

1. Ein mehrschichtiger polymerer Spritzgussartikel mit einer elektrischen Schaltung, wobei der genannte Artikel umfasst:
eine Verbundfolie;
ein Spritzgussteil (2), in das die Verbundfolie durch Spritzgießen eingebettet ist und bündig mit einer Oberfläche des Spritzgussteils abschließt;
wobei die genannte Verbundfolie umfasst:
eine Trägerschicht für Schaltkreise (5), bestehend aus einer dünnen, flexiblen Folie aus Polymerwerkstoff;
eine oder mehrere elektrische Leiterbahnen (4), die auf einer Seite der genannten Trägerschicht (5) aufgedruckt sind;
eine oder mehrere elektrisch leitende Crimpverbinder (3), die jeweils mit der Trägerschicht (5) und einer Leiterbahn (4) vercrimpt sind;
eine Verkapselungsschicht (8) bestehend aus einer dünnen, flexiblen Folie aus Polymerwerkstoff,
**dadurch gekennzeichnet, dass** die genannte Trägerschicht (5) Leiterbahnen (4), Crimpvebinder (3) und Verkapselungsschicht (8) in der Verbundfolie aufeinander laminiert sind; und
wobei die Crimpverbinder (3) und die Verkapselungsschicht (8) so angeordnet sind, dass die Crimpverbinder (3) aus der äußersten Schicht des Spritzgussartikels herausstehen,
wobei die Verbundfolie in das Spritzgussteil (2) eingebettet und die Verkapselungsschicht (8) dem Spritzgussteil (2) zugewandt ist,
wobei die Verbundfolie ferner ein abnehmbares Schutzschichtelement (8') umfasst, das die Crimpverbinder (3) und die Trägerschicht (5) in dem Bereich abdeckt, in dem die Crimpverbinder (3) herausstehen, so dass die Verbundfolie kein leitendes Element auf ihrer Außenseite aufweist.

2. Artikel nach Anspruch 1, der ferner ein oder mehrere elektronische Bauteile (6, 7) umfasst, die auf derselben Seite der Trägerschicht (5) wie die Leiterbahn oder Leiterbahnen (4) angeordnet sind, wobei die genannten Bauteile (6, 7) mit der Leiterbahn oder den Leiterbahnen (4) elektrisch verbunden sind und die genannten elektronischen Bauteile (6, 7) ebenfalls in der Verbundfolie aufeinander laminiert sind.

3. Artikel nach dem vorangehenden Anspruch, wobei die Verkapselungsschicht (8) transparent oder weiß oder farbig durchscheinend ist.

4. Artikel nach Anspruch 1 oder 2, wobei die Verbundfolie in das Spritzgussteil (2) eingebettet und die Trägerschicht (5) dem Spritzgussteil (2) zugewandt ist.

5. Artikel nach dem vorangehenden Anspruch, wobei die Verbundfolie ferner eine sekundäre Verkapselungsschicht (9) umfasst, die die Crimpverbinder (3) und die Trägerschicht (5) in dem Bereich, in dem die Crimpverbinder (3) herausstehen, abdeckt.

6. Artikel nach einem der Ansprüche 4 - 5, wobei die Verbundfolie ferner ein abnehmbares Schutzschichtelement (8') umfasst, das die Crimpverbinder (3) und die Leiterbahnen (4) in dem Bereich abdeckt, in dem die Crimpverbinder (3) herausstehen, so dass die Verbundfolie kein leitendes Element auf ihrer Außenseite aufweist.

7. Artikel nach einem der vorangehenden Ansprüche, wobei die elektronischen Bauteile Leuchtdioden - LEDs, Elektrolumineszenzlampen, Widerstände oder eine Kombination davon sind.

8. Artikel nach einem der vorangehenden Ansprüche, wobei die Leiterbahnen (4) mit einer Paste auf Silberbasis aufgedruckt werden.

9. Artikel nach einem der vorangehenden Ansprüche, wobei die elektronischen Bauteile mit der genannten Leiterbahn oder den genannten Leiterbahnen durch eine Paste auf Silberbasis oder durch sekundäre Crimpverbinder elektrisch verbunden sind.

10. Artikel nach den vorangehenden Ansprüchen ferner umfassend ein textiles oder nicht textiles Material oder deren Mischungen, die das Spritzgussteil (2) abdecken.

11. Artikel nach einem der vorangehenden Ansprüche, wobei die Stärke der Trägerschicht (5) zwischen 25 - 150 Mikrometern, vorzugsweise zwischen 50 - 125 Mikrometern, besonders bevorzugt zwischen 75 - 105 Mikrometern liegt.

12. Artikel nach einem der vorangehenden Ansprüche, wobei die Stärke der Verbundfolie zwischen 100 - 2000 Mikrometern, vorzugsweise zwischen 150 - 1000 Mikrometern, besonders bevorzugt zwischen 170 - 800 Mikrometern liegt.

13. Artikel nach einem der vorangehenden Ansprüche, wobei die Trägerschicht (5) ein Polymerwerkstoff ist, der aus einer im Folgenden genannten Liste ausgewählt wird: Polyolefin, Polyethylen, Polypropylen, Polyester, Polyethylenterephthalat, Polyethylenterephthalatglykol oder Mischungen davon.

14. Artikel nach den vorangehenden Ansprüchen, wobei das Verkapselungsmaterial Polyethylenterephthalatglykol ist.

15. Artikel nach den vorangehenden Ansprüchen, wobei das Teil die Säule eines Autos, eine Autotürverkleidung, eine Autotür, eine Autoarmlehne, eine Autokonsole, eine Autoinstrumententafel, ein Autohandschuhfach, eine Autokofferraumklappe oder eine Autokofferraumverkleidung oder ein Kindersitz für Autos oder ein elektrisches Haushaltsgerät ist.

16. Auto, das ein in einem der vorangehenden Ansprüche beschriebenes Teil umfasst.

17. Verfahren zur Herstellung eines mehrschichtigen polymeren Spritzgussartikels mit einer elektrischen Schaltung, wobei das genannte Verfahren folgende Schritte umfasst:
Einlegen einer Verbundfolie, wie in einem der Ansprüche 1-16 beschrieben, in eine Spritzgussform des Artikels, wobei die Verbundfolie ferner mit einem abnehmbaren Schutzschichtelement (8') ausgestattet ist, das die Crimpverbinder (3) in dem Bereich abdeckt, in dem die Crimpverbinder (3) herausstehen , so dass die Verbundfolie kein leitendes Element auf ihrer Außenseite aufweist;
Aufbringen einer elektrostatischen Ladung auf die Verbundfolie um die genannte Folie elektrostatisch aufzuladen und die genannte Verbundfolie an der Form zu befestigen;
Schließen der Form und Einspritzen des Kunststoffmaterials um ein Spritzgussteil (2) zu erhalten, wobei die Verbundfolie durch ein Teil der Spritzgussform bündig mit einer Oberfläche des Spritzgussteils eingebettet wird;
Entfernen des abnehmbaren Schutzschichtelements (8');
wobei die Crimpverbinder (3) und die Verkapselungsschicht (8) so angeordnet sind, dass die Crimpverbinder (3) aus der äußersten Schicht des Spritzgussartikels herausstehen.

## Revendications

1. Un article moulé par injection à couches multiples polymère comprenant un circuit électrique, ledit article comprenant :
un film stratifié;
une partie moulée par injection (2), dans laquelle le film stratifié a été scellé par moulage par injection, au niveau d'une surface de la partie moulée par injection ;
dans lequel ledit film stratifié comprend :
une couche de support de circuit (5) composée d'une fine feuille flexible de matériau polymère ;
un ou plusieurs tracés de circuit conducteurs (4) imprimés sur l'un des côtés de ladite couche de support (5) ;
un ou plusieurs connecteurs à sertir électriquement conducteurs (3), chacun sertissant la couche de support (5) et des tracés de circuit conducteurs (4) ;
une couche d'encapsulation (8) composée d'une fine feuille flexible de matériau polymère,
charactérisé en ce que ladite couche de support (5), lesdits tracés de circuit (4), lesdits connecteurs à sertir (3) et ladite couche d'encapsulation (8) ont été stratifiés ensembles dans le film stratifié ;
et
dans lequel les connecteurs à sertir (3) et la couche d'encapsulation (8) sont placés de façon à ce que les connecteurs à sertir (3) dépassent de la couche la plus externe de l'article moulé par injection,
dans lequel le film stratifié est scellé à la partie moulée par injection (2) avec la couche d'encapsulation (8) face à la partie moulée par injection (2)
dans lequel le film stratifié comprend également un élément de couche protectrice amovible (8') couvrant les connecteurs à sertir (3) et la couche de support (5) dans la zone où les connecteurs à sertir (3) dépassent, de façon à ce que le film stratifié ne présente aucun élément conducteur sur sa face extérieure.

2. Article selon la revendication 1 comprenant également un ou plusieurs composants électroniques (6, 7) placés sur le même côté de la couche de support (5) que le ou les tracé(s) du circuit (4), lesdits composants (6, 7) étant connectés électriquement audit (auxdits) tracé(s) de circuit (4) et où lesdits composants électroniques (6, 7) ont également été stratifiés ensembles dans le film stratifié.

3. Article selon la revendication antérieur dans lequel la couche d'encapsulation (8) est transparente ou blanc translucide ou de couleur translucide.

4. Article selon la revendication 1 ou 2 dans lequel le film stratifié est scellé à la partie moulée par injection (2) avec la couche de support (5) face à la partie moulée par injection (2).

5. Article selon la revendication antérieur dans lequel le film stratifié comprend également une couche d'encapsulation secondaire (9) couvrant les connecteurs à sertir (3) et la couche de support (5) dans la zone où les connecteurs à sertir (3) dépassent.

6. Article selon l'une quelconque des revendications 4-5 dans lequel le film stratifié comprend également un élément de couche protectrice amovible (8') couvrant les connecteurs à sertir (3) et les tracés conducteurs (4) dans la zone où les connecteurs à sertir (3) dépassent, de façon à ce que le film stratifié ne présente aucun élément conducteur sur sa face extérieure.

7. Article selon l'une quelconque des revendications antérieures dans lequel les composants électroniques sont des diodes émetteurs de lumière - LED's, lampes électroluminescentes, resistors ou une combinaison de ceux-ci.

8. Article selon l'une quelconque des revendications antérieures dans lequel les tracés de circuit conducteurs (4) sont imprimés à l'aide d'une pâte à base d'argent.

9. Article selon l'une quelconque des revendications antérieures dans lequel les composants électroniques sont connectés électriquement audit (auxdits) tracé(s) du circuit par une pâte à base d'argent ou par des connecteurs à sertir secondaires.

10. Article selon les revendications antérieures comprenant également un matériau textile ou non textile ou un mélange de ceux-ci couvrant la partie moulée par injection (2).

11. Article selon l'une quelconque des revendications antérieures dans lequel l'épaisseur de la couche de support (5) est comprise entre 25-150 micromètres, de préférence entre 50-125 micromètres, plus préférablement entre 75-105 micromètres.

12. L'article selon l'une quelconque des revendications antérieures dans lequel l'épaisseur du film stratifié est comprise entre 100-2000 micromètres, de préférence entre 150-1000 micromètres, plus préférablement entre 170-800 micromètres.

13. Article selon l'une quelconque des revendications antérieures dans lequel la couche de support (5) est un matériau polymère sélectionné à partir d'une liste qui inclut: polyoléfine, polyéthylène, polypropylène, polyesters, polyéthylène téréphtalate, polyéthylène téréphtalate glycol, ou un mélange de ceux-ci.

14. Article selon les revendications antérieures dans lequel le matériau d'encapsulation est du polyéthylène téréphtalate glycol.

15. Article selon les revendications antérieures dans lequel l'article est un montant de voiture, un cadre de porte de voiture, une porte de voiture, un accoudoir de voiture, une console de voiture, un tableau de bord de voiture, une boîte-à-gant de voiture, une porte de coffre de voiture, ou un cadre de coffre de voiture, ou un siège auto ou un electroménager.

16. Voiture comprenant un article décrit dans l'une quelconque des revendications antérieures.

17. Méthode de production d'un article moulé par injection à couches multiples polymère comprenant un circuit électrique, ladite méthode comprenant les étapes suivantes :
placer un film stratifié comme décrit dans l'une quelconque des revendications 1-16 dans un moule permettant de mouler l'article par injection, dans lequel le film stratifié est également fournit avec un élément de couche protectrice amovible (8') couvrant les connecteurs à sertir (3) dans la zone où les connecteurs à sertir (3) dépassent, de façon à ce que le film stratifié ne présente aucun élément conducteur sur sa face extérieure ;
appliquer une charge électrostatique sur le film stratifié pour charger ledit film électrostatiquement et attacher ledit film stratifié au moule ;
fermer le moule et injecter le matériau plastique afin d'obtenir une partie moulée par injection (2), dans lequel le film stratifié est scellé par la partie moulée par injection, au nivea d'une surface de la partie moulée par injection ;
retirer l'élément de couche protectrice amovible (8');
dans laquelle les connecteurs à sertir (3) et la couche d'encapsulation (8) sont placés de façon à ce que les connecteurs à sertir (3) dépasseront de la couche la plus externe de l'article moulé par injection.
